# EUROPÄISCHE PATENTSCHRIFT

(11) **EP 3 667 742 B1**
(45) Veröffentlichungstag und Bekanntmachung des Hinweises auf die Patenterteilung: **05.08.2026**
(21) Anmeldenummer: 19000542.1
(22) Anmeldetag: 02.12.2019
(51) Int. Cl.: H10F 10/142, H10F 77/124, H10F 77/14

(54) **STAPELFÖRMIGE MONOLITHISCHE AUFRECHT-METAMORPHE MEHRFACHSOLARZELLE**
STACKED MONOLITHIC UPRIGHT METAMORPHIC MULTIJUNCTION SOLAR CELL
CELLULE SOLAIRE À MULTIJONCTION, MÉTAMORPHIQUE VERTICALE, MONOLITHIQUE, EMPILÉE

(30) Priorität: 14.12.2018 DE 102018009744
(43) Veröffentlichungstag der Anmeldung: 17.06.2020
(73) Patentinhaber: AZUR SPACE Solar Power GmbH, 74072 Heilbronn (DE)
(72) Erfinder: Fuhrmann, Daniel, 74081 Heilbronn (DE); Van Leest, Rosalinda, 74076 Heilbronn (DE); Meusel, Matthias, 74076 Heilbronn (DE)
(74) Vertreter: Koch Müller Patentanwaltsgesellschaft mbH

(56) Entgegenhaltungen:
- EP-A1- 2 251 912
- JP-A- 2011 077 293
- US-A1- 2017 077 340
- US-A1- 2017 222 066
- US-A1- 2018 315 879
- ENRIQUE BARRIGÓN ET AL: "Highly conductive p++AlGaAs/n++GaInP tunnel junctions for ultra-high concentrator solar cells", PROGRESS IN PHOTOVOLTAICS: RESEARCH AND APPLICATIONS, vol. 22, no. 4, 15 February 2014 (2014-02-15), pages 399 - 404, XP055203912, ISSN: 1062-7995, DOI: 10.1002/pip.2476
- CAMPESATO R ET AL: "High efficiency solar cells based on AlInGaP", PHOTOVOLTAIC SPECIALISTS CONFERENCE (PVSC), 2009 34TH IEEE, IEEE, PISCATAWAY, NJ, USA, 7 June 2009 (2009-06-07), pages 1112 - 1117, XP031626502, ISBN: 978-1-4244-2949-3

## Beschreibung

Die Erfindung betrifft eine stapelförmige, monolithische, aufrecht-metamorphe Mehrfachsolarzelle.

Ein monolithischer aufrecht-metamorpher Solarzellenstapel ist aus W. Guter et al, "Investigation and development of III-V-triple-junction concentrator solar cells", in 22nd European Photovoltaic Solar Energy Conference, 3-7 September 2007, Milan Italy, S.122-125, bekannt.

Andere Mehrfachsolarzellen sind aus der US 2017 / 222 066 A1 und aus Campesto et al., "High efficiency solar cells based on AlInGaP", 34th Photovoltaic Specialists Conferencs (PVSC), 7. Juni 2009, Seiten 1112-1117, XP031626502, ISBN: 978-1-4244-2949-3 bekannt.

Aus der EP 2 251 912 A1 ist eine stapelförmige monolithische Mehrfachsolarzelle mit verbesserter Stromleitung zwischen den Solarzellen bekannt. Hierzu wird zwischen zwei aufeinanderfolgenden Solarzellen eine Tunneldiode mit zueinander verspannten entarteten Schichten angeordnet.

Eine tensil verspannte entartete Schicht ist mit einer kompressiv verspannten entarteten Schicht kompensiert. Die entarteten Schichten sind entweder als mit Kohlenstoff dotierte entartete p+- oder als mit Tellur oder Silizium dotierte entartete n+-Schichten ausgeführt. Indem die Verspannung kompensiert ist, wirkt keine Verspannung auf die die Tunneldiode umgebenden Schichten, anders ausgedrückt die Summe der Verspannung ist null.

Tunneldioden mit verspannten Schichten sind außerdem aus der US 2017 / 077 340 A1 bekannt.

In der US 2018 / 315 879 A1 werden Mehrfachsolarzellen mit einer Tunneldiode mit einer Quantentopf-Struktur als Zwischenschicht offenbart.

Aus der JP 2011 077 293 A ist eine Mehrfachsolarzelle mit InGaP/AlGaAs Hetero-Tunneldiode mit InSb-Zwischenschicht bekannt. Eine InGaP/AlGaAs Hetero-Tunneldiode mit einer hochdotierten GaAs Zwischenschicht ist aus E. Barrigón et al., "Highly conductive p++AlGaAs/n++GaInP tunnel junctions for ultrahigh concentrator solar cells", Progress in Photovoltaics: Research and Applications, Bd. 22, Nr. 4, 15. Februar 2014, Seiten 399-404, XP055203912, ISSN: 1062-7995, DOI: 10,1002/pip, 2476 bekannt.

Aus der US 2010/0319764 A1 ist eine Mehrfachsolarzelle mit einer Nitridhaltigen Teilzelle bekannt, wobei eine Steigerung des Tunnelstroms der Mehrfachsolarzelle durch eine Wärmebehandlung erreicht wird. Negative Einflüsse der Wärmebehandlung werden auf die Tunneldioden werden verhindert, indem die Tunneldioden eine Schichtfolge aus mehreren n- und p-dotierten Schichten und eine ErAs-Zwischenschicht umfassen.

In "Numerical analysis of p-GaAs/n-GaAs tunnel junction emplying InAs intermediate layer for high concentrated photovoltaic applications", Seokjin Kang et al., Journal of Physics: conference Series, 490, 2014, 012178. ISSN 1742-6596 werden Untersuchungsergebnisse zu einer Zweifachsolarzelle mit GaAs-Tunneldiode mit dünner InAs-Zwischenschicht vorgestellt.

Verschiedene Mehrfachsolarzellen sind aus der US 2017/0222066 A1 sowie aus der EP 1 134 813 A2 bekannt.

Vor diesem Hintergrund besteht die Aufgabe der Erfindung darin, eine Vorrichtung anzugeben, die den Stand der Technik weiterbildet.

Die Aufgabe wird durch eine Mehrfachsolarzelle mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige monolithische aufrecht-metamorphe Mehrfachsolarzelle bereitgestellt, aufweisend mindestens eine erste Teilzelle, eine zweite Teilzelle, einen metamorphen Puffer und mindestens eine erste Tunneldiode.

Die erste Teilzelle weist eine erste Bandlücke und eine erste Gitterkonstante auf und besteht zu mehr als 50% aus Germanium.

Die zweite Teilzelle ist über der ersten Teilzelle angeordnet und weist eine zweite Bandlücke und eine zweite Gitterkonstante auf, wobei die zweite Bandlücke größer als die erste Bandlücke und die zweite Gitterkonstante größer als die erste Gitterkonstante ist.

Der metamorphe Puffer ist zwischen der ersten Teilzelle und der zweiten Teilzelle angeordnet.

Die erste Tunneldiode ist zwischen dem metamorphen Puffer und der zweiten Teilzelle angeordnet und weist eine n⁺-Schicht und eine p⁺-Schicht auf. Die n⁺-Schicht der ersten Tunneldiode umfasst InAlP, die p⁺-Schicht der ersten Tunneldiode umfasst ein As-haltiges III-V Material. Zwischen der n⁺-Schicht und der p⁺-Schicht ist eine Zwischenschicht angeordnet, wobei die Zwischenschicht jeweils dünner ist als die n⁺-Schicht und als die p⁺-Schicht.

Es versteht sich weiterhin, dass der Begriff der Teilzelle synonym mit dem Begriff der Teilsolarzelle verwendet wird. Anders ausgedrückt besteht der Solarzellenstapel aus mehreren Teilsolarzellen, die miteinander mittels Tunneldioden in Serie verschaltet sind.

Es sei angemerkt, dass die verschiedenen Schichten neben den angegebenen Materialien, beispielsweise InAlP oder As-haltiges III-V Material, zusätzlich auch weitere Elemente umfassen können.

Auch sei angemerkt, dass die Zwischenschicht einteilig ausgebildet ist und epitaktisch mittels MOVPE hergestellt wird. Es versteht sich, dass zwischen zwei Teilzellen jeweils eine Tunneldiode ausgebildet ist.

Des Weiteren sei angemerkt, dass der metamorphe Puffer vorzugsweise eine Abfolge von mindestens drei Schichten umfasst, wobei jede Schicht eine Gitterkonstante aufweist und die Gitterkonstanten der Schichten in Richtung der zweiten Teilzelle von Schicht zu Schicht ansteigt.

Alternativ weist der metamorphe Puffer zwischen einer unteren Schicht und einer oberen Schicht eine nahezu lineare Änderung der Gitterkonstanten und / oder der Dotierung auf.

Bestehen Schichten aus einer gegebenen Materialkomposition, versteht es sich, dass zusätzlich zu der angeführten Materialkomposition insbesondere Dotierstoffe wie beispielsweise Zink oder Kohlenstoff oder Silizium mitumfasst sind, ohne dass die Dotierstoffe explizit erwähnt sind.

Ein Vorteil der erfindungsgemäßen Zwischenschicht ist, dass mittels der Zwischenschicht ein unerwünschter Einbau von einem n-Dotierstoff in die p+-Schicht der Tunneldiode verringern lässt. Anders ausgedrückt, es lässt sich eine Cross-Kontamination verringern.

Es zeigte sich in überraschender Weise, dass sich der unerwünschte Einbau des n-Dotierstoffs mittels As-haltigen Schichten besser unterdrücken lässt, als mit phosphidhaltigen Schichten. Der Fachmann ist bisher fälschlicherweise davon ausgegangen, dass sich As-haltige Schichten, insbesondere GaAs wegen den Absorptionsverlusten nicht eignen. Durch die Absorptionsverluste wird der Wirkungsgrad der Mehrfachzelle verringert, indem die darunter liegenden Teilzellen weniger Licht erhalten.

Die störende Absorption lässt sich jedoch unterdrücken, indem die GaAs Schicht sehr dünn, d.h. wenige nm dick auszuführen ist, dass sich in den Quantentöpfen der As-haltigen Zwischenschicht keine Zustände bzw. keine absorbierende Niveaus befinden.

Hierdurch ist es möglich eine hohe Transparenz der Tunneldiode für die unter der Tunneldiode liegenden Teilzellen zu erreichen und gleichzeitig eine Tunneldiode mit einer hohen Peakstromdichte bereitzustellen und den Wirkungsgrad der Mehrfachsolarzelle zu erhöhen.

Erfindungsgemäß umfasst die n⁺-Schicht der ersten Tunneldiode InₓAl₁₋ₓP mit x > 0,55 oder mit x > 0,6 oder mit x ≥ 0,65. InAlP bildet mit diesem ausreichend hohen Indium-Gehalt einen direkten Halbleiter. Im Vergleich zu üblichen InGaAs-oder InGaP Schichten wird eine deutlich höhere Transparenz erreicht.

Einer aufgrund der höheren Bandlücke von InAlP auftretenden Reduktion des Tunnelstroms wird durch die erfindungsgemäße Zwischenschicht, bevorzugt eine GaAs-Zwischenschicht, entgegengewirkt.

Auch zeigt sich, dass InAlP mit einem niedrigeren Indium-Gehalt, z.B. x < 0,5 für die n+-Schicht überraschenderweise nicht geeignet ist, da es einen indirekten Halbleiter bildet.

Erfindungsgemäß umfasst die Zwischenschicht As, wobei ein As-Gehalt der Zwischenschicht höher als ein As-Gehalt der n⁺-Schicht ist.

Erfindungsgemäß umfasst die Zwischenschicht GaAs oder AlGaAs oder AlInAs oder InGaAs oder AlInGaAs.

Erfindungsgemäß weist die Zwischenschicht eine Dicke kleiner 6 nm oder kleiner 4 nm auf und ist mit Silizium mit einer Dotierstoffkonzentration von mindestens 10¹⁸ N/cm³ dotiert.

In einer Weiterbildung weist die Zwischenschicht eine Energiebandlücke von ≥ 1.08 eV auf.

Gemäß einer weiteren Weiterbildung ist die n⁺-Schicht der ersten Tunneldiode mit Silizium und/oder mit Tellur und/oder mit Selen und/oder mit Schwefel mit einer Dotierstoffkonzentration von ≥ 10¹⁹ N/cm³ dotiert.

Die n⁺-Schicht der ersten Tunneldiode umfasst in einer weiteren Ausführungsform Gallium und gemäß einer Weiterbildung AlₓGa_{y}In_{1-x-y}P mit 0 ≤ y < 0,15 oder 0 ≤ y < 0,05 oder 0 ≤ y < 0,01.

In einer weiteren Ausführungsform umfasst die p⁺-Schicht der ersten Tunneldiode AlInAs und gemäß einer Weiterbildung AlₓGa_{y}In_{1-x-y}As mit x>0,4.

In einer anderen Weiterbildung ist die p⁺-Schicht der ersten Tunneldiode mit Kohlenstoff dotiert.

Gemäß einer anderen Ausführungsform entspricht eine Gitterkonstante der n⁺-Schicht der ersten Tunneldiode der zweiten Gitterkonstanten der zweiten Teilzelle und eine Gitterkonstante der p⁺-Schicht der ersten Tunneldiode ist gleich oder kleiner als die zweite Gitterkonstante der zweiten Teilzelle.

In wieder einer anderen Ausführungsform weist die Mehrfachsolarzelle weitere Teilzellen auf, wobei jede Teilzelle jeweils eine weitere Bandlücke aufweist, die weiteren Teilzellen zwischen der ersten Tunneldiode und der ersten Teilzelle angeordnet sind und die Bandlücken der weiteren Teilzellen jeweils größer als die erste Bandlücke der ersten Teilzelle und jeweils kleiner als die zweite Bandlücke der zweiten Teilzelle sind.

In einer Weiterbildung weist die Mehrfachsolarzelle mindestens eine weitere Tunneldiode auf. Die mindestens eine weitere Tunneldiode weist gemäß einer weiteren Weiterbildung eine weitere Zwischenschicht auf, wobei eine n⁺-Schicht der weiteren Tunneldiode InAlP oder InGaP umfasst, eine p⁺-Schicht der weiteren Tunneldiode ein As-haltiges III-V Material umfasst, die weitere Zwischenschicht zwischen n⁺-Schicht und p⁺-Schicht der weiteren Tunneldiode angeordnet ist und die weitere Zwischenschicht jeweils dünner als die n⁺₋Schicht und als die p⁺-Schicht der weiteren Tunneldiode ist.

Bevorzugt umfasst die unterste Tunneldiode der weiteren Tunneldioden eine andere Zusammensetzung oder ist ohne Zwischenschicht ausgebildet.

Gemäß einer anderen Ausführungsform ist die Mehrfachzelle als Ge / InGaAs / AlInGaAs / AlInGaP 4-fach Zelle ausgebildet, wobei die n⁺-Schicht der ersten Tunneldiode (TD1) InAlP umfasst. Es versteht sich, dass in der Ge / InGaAs / AlInGaAs / AlInGaP 4-fach Zelle die Teilsolarzelle SC2 aus AlInGaP gebildet ist und die Tunneldiode TD1 unterhalb der AlInGaP Tellsolarzelle angeordnet ist.

In einer anderen alternativen Ausführungsform ist die Mehrfachsolarzelle als Ge / InGaAs / AlInGaAs / InGaP/ AlInGaP 5-fach Zelle ausgebildet, wobei die n⁺-Schicht der ersten Tunneldiode (TD1) InAlP umfasst. Es versteht sich, dass in der Ge / InGaAs / AlInGaAs / InGaP/ AlInGaP 5-fach Zelle die Tellsolarzelle SC2 aus AlInGaP gebildet ist und die Tunneldiode TD1 unterhalb der AlInGaP Teilsolarzelle angeordnet ist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die:
- Figur 1: eine schematische Ansicht auf eine erste erfindungsgemäße Ausführungsform einer stapelförmigen monolithischen aufrecht-metamorphen Mehrfachsolarzelle,
- Figur 2: eine schematische Ansicht auf eine zweite erfindungsgemäße Ausführungsform der Mehrfachsolarzelle,
- Figur 3: eine schematische Ansicht auf eine dritte erfindungsgemäße Ausführungsform der Mehrfachsolarzelle
- Figur 4: eine schematische Ansicht auf eine vierte erfindungsgemäße Ausführungsform der Mehrfachsolarzelle.

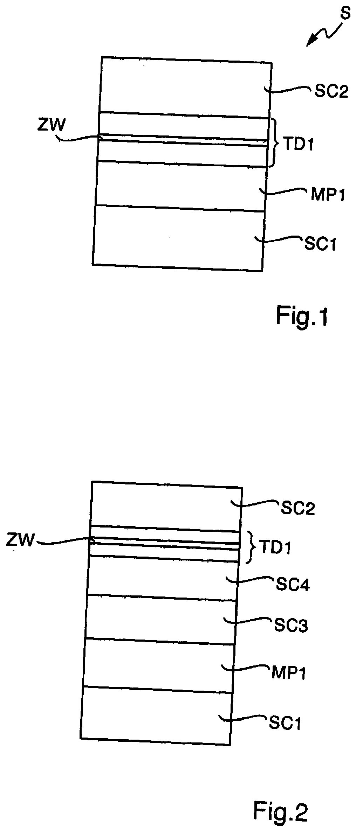

Die Abbildung der Figur 1 zeigt eine stapelförmige monolithische aufrecht-metamorphe Mehrfachsolarzelle S aufweisend eine erste Teilzelle SC1 als unterste Teilzelle gefolgt von einem metamorphen Puffer MP1, einer Tunneldiode TD1 und einer zweite Teilzelle SC2 als oberster Teilzelle.

Die erste Teilzelle SC1 weist eine erste Bandlücke EG1 und eine erste Gitterkonstante A1 auf und besteht zu mehr als 50% aus Germanium.

Die zweite Teilzelle weist eine zweite Bandlücke EG2 auf und eine zweite Gitterkonstante A2 auf, wobei die zweite Bandlücke EG2 größer als die erste Bandlücke EG1 ist und sich die zweite Gitterkonstante A2 von der ersten Gitterkonstante A1 unterscheidet.

Der metamorphe Puffer MP1 gleicht die Unterschiede zwischen den Gitterkonstanten A1 und A2 aus und umfasst hierfür eine Abfolge von mindestens drei Schichten mit in Richtung der zweiten Teilzelle SC2 von Schicht zu Schicht ansteigenden Gitterkonstanten.

Die Tunneldiode TD1 ist zwischen dem metamorphen Puffer MP1 und der zweiten Teilzelle SC2 angeordnet und weist eine n⁺-Schicht, eine p⁺-Schicht und eine zwischen der n⁺-Schicht und der p⁺-Schicht angeordnete Zwischenschicht ZW auf.

Die n⁺-Schicht der ersten Tunneldiode TD1 umfasst InAlP und die p⁺-Schicht der ersten Tunneldiode TD1 umfasst ein As-haltiges III-V Material.

Die Zwischenschicht ZW ist jeweils dünner ist als die n⁺₋Schicht und als die p⁺-Schicht ausgebildet.

In der Abbildung der Figur 2 ist eine weitere Ausführungsform dargestellt. Im Folgenden werden nur die Unterschiede zu der Abbildung der Figur 1 erläutert.

Die Mehrfachsolarzelle S umfasst zusätzlich eine dritte Teilzelle SC3 und eine vierte Teilzelle SC4, wobei die beiden weiteren Teilzellen SC3 und SC4 jeweils gitterangepasst zu der zweiten Teilzelle SC2 ausgebildet und zwischen dem metamorphen Puffer MP1 und der Tunneldiode TD1 angeordnet sind.

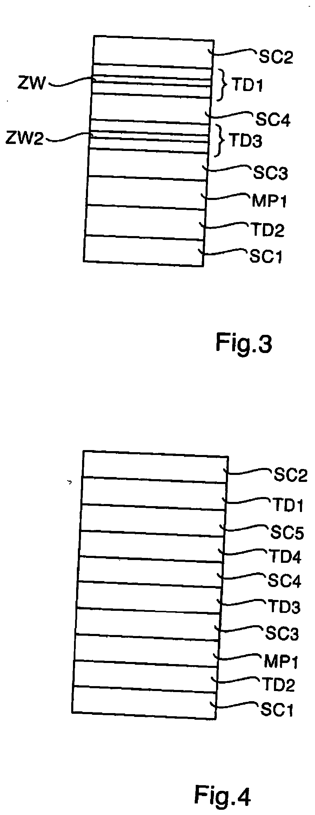

In der Abbildung der Figur 3 ist eine weitere Ausführungsform dargestellt. Im Folgenden werden nur die Unterschiede zu der Abbildung der Figur 2 erläutert.

In dieser Ausführungsform umfasst die Mehrfachsolarzelle S zusätzlich zu der dritten und vierten Teilzelle SC3 und SC4 noch eine weitere Tunneldiode TD3 mit einer erfindungsgemäßen Zwischenschicht. Die n⁺-Schicht der weiteren Tunneldiode umfasst InAIP oder InGaP, wobei die p⁺-Schicht der weiteren Tunneldiode ein As-haltiges III-V Material umfasst.

Während eine zweite Tunneldiode TD2 zwischen dem metamorphen Puffer MP1 und der ersten Teilzelle SC1 eine n⁺-Schicht und eine p⁺-Schicht, aber keine Zwischenschicht umfasst, ist die dritte Tunneldiode TD3 zwischen der dritten Teilzelle SC3 und der vierten Teilzelle SC4 entsprechend der ersten Tunneldiode TD1 aufgebaut.

Die dritte Tunneldiode TD3 weist entsprechend zwischen einer p⁺-Schicht und einer n⁺-Schicht eine weitere Zwischenschicht ZW2 auf.

Die erste Teilzelle SC1 ist als Ge-Solarzelle bzw. Substrat ausgebildet, die dritte Teilzelle SC3 umfasst InGaAs, die vierte Teilzelle SC4 InAlGaAs und die zweite Teilzelle InAlGaP. Die p+-Schicht der ersten Tunneldiode TD1 umfasst AlInGaAs, die n+-Schicht umfasst InAlP und die Zwischenschicht ZW umfasst Ga(Al)As.

In der Abbildung der Figur 4 ist eine weitere Ausführungsform dargestellt. Im Folgenden werden nur die Unterschiede zu der Abbildung der Figur 3 erläutert.

Die Mehrfachsolarzelle ist als 5-fach Zelle ausgebildet. Auf der als Ge-Substrat ausgebildeten ersten Teilzelle SC1 ist eine zweite Tunneldiode TD2 angeordnet, wobei die zweite Tunneldiode TD2 keine Zwischenschicht umfasst.

Auf der zweiten Tunneldiode TD2 folgt der metamorphe Puffer MP1, eine dritte Teilzelle SC3 aus InGaAs, eine dritte Tunneldiode TD3, eine vierte Teilzelle aus InAlGaAs, eine vierte Tunneldiode TD4, eine fünfte Teilzelle aus InGaP, die erste Tunneldiode TD1 sowie die zweite Teilzelle aus InAlGaP.

Die erste Tunneldiode umfasst eine AlInGaAs-Schicht als p+-Schicht, eine InAIP-Schicht als n+-Schicht und zwischen der n+-Schicht und der p+-Schicht eine Zwischenschicht ZW aus Ga(Al)As.

Die zweite Tunneldiode TD2 weist keine Zwischenschicht auf.

Die dritte und die vierte Tunneldiode TD3 und TD4 weisen im dargestellten Ausführungsbeispiel, wie die zweite Tunneldiode TD1, keine Zwischenschicht auf. Im dargestellten Ausführungsbeispiel umfasst die n⁺-Schicht der dritten und vierten Tunneldiode InGaP oder InAlP.

Alternativ umfasst auch die vierte Tunneldiode TD4 eine Zwischenschicht. Wiederum alternativ umfasst zusätzlich zu der vierten Tunneldiode TD4 auch die dritte Tunneldiode TD3 eine Zwischenschicht.

## Patentansprüche

1. Stapelförmige monolithische aufrecht-metamorphe Mehrfachsolarzelle (S) aufweisend
- mindestens eine erste Teilzelle (SC1) mit einer ersten Bandlücke (EG1), einer ersten Gitterkonstante (A1) und zu mehr als 50% aus Germanium bestehend,
- eine über der ersten Teilzelle (SC1) angeordnete zweite Teilzelle (SC2) mit einer zweiten Bandlücke (EG2) und einer zweiten Gitterkonstante (A2),
- einen zwischen der ersten Teilzelle (SC1) und der zweiten Teilzelle (SC2) angeordneten metamorphen Puffer (MP1), und
- eine zwischen dem metamorphen Puffer (MP1) und der zweiten Teilzelle (SC2) angeordnete erste Tunneldiode (TD1) mit einer n⁺-Schicht und einer p⁺-Schicht, wobei
- die p⁺-Schicht der ersten Tunneldiode (TD1) ein As-haltiges III-V Material umfasst,
- die zweite Bandlücke (EG2) größer als die erste Bandlücke (EG1) ist und
- die zweite Gitterkonstante (A2) größer als die erste Gitterkonstante (A1) ist, **dadurch gekennzeichnet, dass**
- zwischen der n⁺-Schicht und der p⁺-Schicht eine Zwischenschicht (ZW) angeordnet ist,
- die Zwischenschicht (ZW) jeweils dünner ist als die n⁺-Schicht und als die p⁺-Schicht,
- die Zwischenschicht (ZW) eine Dicke (D_{zw}) kleiner 6 nm oder kleiner 4 nm aufweist
- die n⁺-Schicht der ersten Tunneldiode (TD1) InₓAl₁₋ₓP mit x > 0,55 oder mit x > 0,6 oder mit x ≥ 0,65 umfasst, und
- die Zwischenschicht (ZW) GaAs oder AlGaAs oder AlInAs oder InGaAs oder AlInGaAs umfasst, und
- mit Silizium mit einer Dotierstoffkonzentration von mindestens 10¹⁸ N/cm³ dotiert ist, und
der As-Gehalt der Zwischenschicht (ZW) höher ist als ein As-Gehalt der n⁺-Schicht.

2. Mehrfachsolarzelle nach einem der vorangegangenen Ansprüche, **dadurch gekennzeichnet, dass** die Zwischenschicht (ZW) eine Energiebandlücke von ≥ 1.08 eV aufweist.

3. Mehrfachsolarzelle nach einem der vorangegangenen Ansprüche, **dadurch gekennzeichnet, dass** die n⁺-Schicht der ersten Tunneldiode (TD1) mit Silizium und/oder mit Tellur und/oder mit Selen und/oder mit Schwefel mit einer Dotierstoffkonzentration von ≥10¹⁹ N/cm³ dotiert ist.

4. Mehrfachsolarzelle nach einem der vorangegangenen Ansprüche, **dadurch gekennzeichnet, dass** die n⁺-Schicht der ersten Tunneldiode (TD1) Gallium umfasst.

5. Mehrfachsolarzelle nach einem der vorangegangenen Ansprüche, **dadurch gekennzeichnet, dass** die n⁺-Schicht der ersten Tunneldiode (TD1) AlₓGa_{y}In_{1-x-y}P mit 0 ≤ y < 0,15 oder 0 ≤ y < 0,05 oder 0 ≤ y < 0,01 umfasst.

6. Mehrfachsolarzelle nach einem der vorangegangenen Ansprüche, **dadurch gekennzeichnet, dass** die p⁺-Schicht der ersten Tunneldiode (TD1) AlInAs umfasst.

7. Mehrfachsolarzelle nach einem der vorangegangenen Ansprüche, **dadurch gekennzeichnet, dass** die p⁺-Schicht der ersten Tunneldiode (TD1) AlₓGa_{y}In_{1-x-y}As mit x>0,4 umfasst.

8. Mehrfachsolarzelle nach einem der vorangegangenen Ansprüche, **dadurch gekennzeichnet, dass** die p⁺-Schicht der ersten Tunneldiode (TD1) mit Kohlenstoff dotiert ist.

9. Mehrfachsolarzelle nach einem der vorangegangenen Ansprüche, **dadurch gekennzeichnet, dass** eine Gitterkonstante der n⁺-Schicht der ersten Tunneldiode (TD1) der zweiten Gitterkonstanten (A2) der zweiten Teilzelle (SC2) entspricht und eine Gitterkonstante der p⁺-Schicht der ersten Tunneldiode (TD1) gleich oder kleiner als die zweite Gitterkonstante (A2) der zweiten Teilzelle (SC2) ist.

10. Mehrfachsolarzelle nach einem der vorangegangenen Ansprüche, **dadurch gekennzeichnet, dass** die Mehrfachsolarzelle weitere Teilzellen (SC3, SC4) jeweils mit weiterer Bandlücke (EG3, EG4) aufweist, wobei die weiteren Teilzellen (SC3, SC4) zwischen der ersten Tunneldiode (TD1) und der ersten Teilzelle (SC1) angeordnet sind und die Bandlücken (EG3, EG4) der weiteren Teilzellen (SC3, SC4) jeweils größer als die erste Bandlücke (EG1) der ersten Teilzelle (SC1) und jeweils kleiner als die zweite Bandlücke (EG2) der zweiten Teilzelle (SC2) sind.

11. Mehrfachsolarzelle nach Anspruch 10, **dadurch gekennzeichnet, dass** die Mehrfachsolarzelle mindestens eine weitere Tunneldiode (TD2, TD3) aufweist.

12. Mehrfachsolarzelle nach Anspruch 10 oder 11, dass die mindestens eine weitere Tunneldiode (TD3) eine weitere Zwischenschicht (ZW2) aufweist, wobei eine n⁺-Schicht der weiteren Tunneldiode (TD3) InAlP oder InGaP umfasst, eine p⁺-Schicht der weiteren Tunneldiode (TD3) ein As-haltiges III-V Material umfasst, die weitere Zwischenschicht (ZW2) zwischen n⁺-Schicht und p⁺-Schicht der weiteren Tunneldiode (TD3) angeordnet ist und die weitere Zwischenschicht (ZW2) jeweils dünner ist als die n⁺₋Schicht und als die p⁺-Schicht der weiteren Tunneldiode (TD3) ist.

13. Mehrfachsolarzelle nach einem der Ansprüche 10 bis 12, **dadurch gekennzeichnet, dass** die Mehrfachsolarzelle als Ge / InGaAs / AlInGaAs / AlInGaP 4-fach Zelle ausgebildet ist oder die Mehrfachsolarzelle als Ge / InGaAs / AlInGaAs / InGaP/ AlInGaP 5-fach Zelle ausgebildet ist.

## Claims

1. **Stacked** monolithic upright metamorphic multi-junction solar cell (S) comprising
- at least one first sub-cell (SC1) with a first band gap (EG1), a first lattice constant (A1) and consisting of more than 50% of germanium,
- a second sub-cell (SC2), which is arranged above the first sub-cell (SC1), with a second band gap (EG2) and a second lattice constant (A2),
- a metamorphic buffer (MP1) arranged between the first sub-cell (SC1) and the second sub-cell (SC2) and
- a first tunnel diode (TD1), which is arranged between the metamorphic buffer (MP1) and the second sub-cell (SC2), with a n⁺ layer and a p⁺ layer, wherein
- the p⁺ layer of the first tunnel diode (TD1) comprises a III-V material containing As,
- the second band gap (EG2) is greater than the first band gap (EG1) and
- the second lattice constant (A2) is greater than the first lattice constant (A1), **characterised in that**
- an intermediate layer (ZW) is arranged between the n⁺ layer and the p⁺ layer,
- the intermediate layer (ZW) is thinner than the n⁺ layer and than the p⁺ layer,
- the intermediate layer (ZW) has a thickness (D_{ZW}) smaller than 6 nm or smaller than 4 nm,
- the n⁺ layer of the first tunnel diode (TD1) comprises InₓAl₁₋ₓP, wherein x > 0.55 or wherein x > 0.6 or wherein x ≥ 0.65 and
- the intermediate layer (ZW) comprises GaAs or AlGaAs or AlInAs or InGaAs or AlInGaAs and
- is doped with silicon with a dopant concentration of at least 10¹⁸ N/cm³ and
- the As content of the intermediate layer (ZW) is higher than an As content of the n⁺ layer.

2. Multi-junction solar cell according to the preceding claim, **characterised in that** the intermediate layer (ZW) has an energy band gap of ≥ 1.08 eV.

3. Multi-junction solar cell according to one of the preceding claims, **characterised in that** the n⁺ layer of the first tunnel diode (TD1) is doped with silicon and/or with tellurium and/or with selenium and/or with sulphur with a dopant concentration of ≥ 10¹⁹ N/cm³.

4. Multi-junction solar cell according to any one of the preceding claims, **characterised in that** the n⁺ layer of the first tunnel diode (TD1) comprises gallium.

5. Multi-junction solar cell according to any one of the preceding claims, **characterised in that** the n⁺ layer of the first tunnel diode (TD1) comprises AlₓGa_{y}In_{1-x-y}P, wherein 0 ≤ y < 0.15 or 0 ≤ y < 0.05 or 0 ≤ y < 0.01.

6. Multi-junction solar cell according to any one of the preceding claims, **characterised in that** the p⁺ layer of the first tunnel diode (TD1) comprises AlInAs.

7. Multi-junction solar cell according to any one of the preceding claims, **characterised in that** the p⁺ layer of the first tunnel diode (TD1) comprises AlₓGa_{y}In_{1-x-y}As, wherein x > 0.4.

8. Multi-junction solar cell according to any one of the preceding claims, **characterised in that** the p⁺ layer of the first tunnel diode (TD1) is doped with carbon.

9. Multi-junction solar cell according to any one of the preceding claims, **characterised in that** a lattice constant of the n⁺ layer of the first tunnel diode (TD1) corresponds with the second lattice constant (A2) of the second sub-cell (SC2) and a lattice constant of the p⁺ layer of the first tunnel diode (TD1) is the same as or smaller than the second lattice constant (A2) of the second sub-cell (SC2).

10. Multi-junction solar cell according to any one of the preceding claims, **characterised in that** the multi-junction solar cell comprises further sub-cells (SC3, SC4) each with a further band gap (EG3, EG4), wherein the further sub-cells (SC3, SC4) are arranged between the first tunnel diode (TD1) and the first sub-cell (SC1) and the band gaps (EG3, EG4) of the further sub-cells (SC3, SC4) are each greater than the first band gap (EG1) of the first sub-cell (SC1) and each smaller than the second band gap (EG2) of the second sub-cell (SC2).

11. Multi-junction solar cell according to claim 10, **characterised in that** the multi-junction solar cell comprises at least one further tunnel diode (TD2, TD3).

12. Multi-junction solar cell according to claim 10 or 11, **characterised in that** the at least one further tunnel diode (TD3) comprises a further intermediate layer (ZW2), wherein an n⁺ layer of the further tunnel diode (TD3) comprises InAlP or InGaP, a p⁺ layer of the further tunnel diode (TD3) comprises a III-V material containing As, the further intermediate layer (ZW2) is arranged between the n⁺ layer and the p⁺ layer of the further tunnel diode (TD3) and the further intermediate layer (ZW2) is thinner than the n⁺ layer and than the p⁺ layer of the further tunnel diode (TD3).

13. Multi-junction solar cell according to one of claims 10 to 12, **characterised in that** the multi-junction solar cell is configured as a Ge / InGaAs / AlInGaAs / AlInGaP fourfold cell or the multi-junction solar cell is configured as a Ge / InGaAs / AlInGaAs / InGaP / AlInGaP fivefold cell.

## Revendications

1. Cellule solaire multiple monolithique en forme d'empilement métamorphe vertical (S) comprenant
- au moins une première sous-cellule (SC1) avec une première bande interdite (EG1), une première constante de réseau (A1) et composée à plus de 50% de germanium,
- une deuxième sous-cellule (SC2) disposée au-dessus de la première sous-cellule (SC1) avec une deuxième bande interdite (EG2) et une deuxième constante de réseau (A2),
- un tampon métamorphe (MP1) disposé entre la première sous-cellule (SC1) et la deuxième sous-cellule (SC2), et
- une première diode tunnel (TD1) disposée entre le tampon métamorphe (MP1) et la deuxième sous-cellule (SC2), avec une couche n⁺ et une couche p⁺ , dans laquelle
- la couche p⁺ de la première diode tunnel (TD1) comprend un matériau III-V contenant de l'arsenic,
- la deuxième bande interdite (EG2) est supérieure à la première bande interdite (EG1) et
- la deuxième constante de réseau (A2) est supérieure à la première constante de réseau (A1), **caractérisée en ce que**
- une couche intermédiaire (ZW) est disposée entre la couche n⁺ et la couche p⁺ ,
- la couche intermédiaire (ZW) est dans chaque cas plus fine que la couche n⁺ et que la couche p⁺ ,
- la couche intermédiaire (ZW) présente une épaisseur (D_{ZW}) inférieure à 6 nm ou inférieure à 4 nm,
- la couche n⁺ de la première diode tunnel (TD1) comprend InₓAl_{1 - x}P avec x > 0,55 ou avec x > 0,6 ou avec x ≥ 0,65, et
- la couche intermédiaire (ZW) comprend GaAs ou AlGaAs ou AlInAs ou InGaAs ou AlInGaAs, et est dopée avec du silicium avec une concentration en dopant d'au moins 10¹⁸ N/cm³, et
la teneur en arsenic de la couche intermédiaire (ZW) est supérieure à une teneur en arsenic de la couche n⁺ .

2. Cellule solaire multiple selon l'une des revendications précédentes, **caractérisée en ce que** la couche intermédiaire (ZW) présente une bande interdite d'énergie de ≥1,08 eV.

3. Cellule solaire multiple selon l'une des revendications précédentes, **caractérisée en ce que** la couche n⁺ de la première diode tunnel (TD1) est dopée avec du silicium et/ou avec du tellure et/ou avec du sélénium et/ou avec du soufre avec une concentration en dopant de ≥10¹⁹ N/cm³.

4. Cellule solaire multiple selon l'une des revendications précédentes, **caractérisée en ce que** la couche n⁺ de la première diode tunnel (TD1) comprend du gallium.

5. Cellule solaire multiple selon l'une des revendications précédentes, **caractérisée en ce que** la couche n⁺ de la première diode tunnel (TD1) comprend AlₓGa_{y}In□_{-x-y}P avec 0 ≤ y < 0,15 ou 0 ≤ y < 0,05 ou 0 ≤ y < 0,01.

6. Cellule solaire multiple selon l'une des revendications précédentes, **caractérisée en ce que** la couche p⁺ de la première diode tunnel (TD1) comprend AlInAs.

7. Cellule solaire multiple selon l'une des revendications précédentes, **caractérisée en ce que** la couche p⁺ de la première diode tunnel (TD1) comprend AlₓGa_{y}In_{□-x-y}As avec x>0,4.

8. Cellule solaire multiple selon l'une des revendications précédentes, **caractérisée en ce que** la couche p⁺ de la première diode tunnel (TD1) est dopée avec du carbone.

9. Cellule solaire multiple selon l'une des revendications précédentes, **caractérisée en ce qu'**une constante de réseau de la couche n⁺ de la première diode tunnel (TD1) correspond à la deuxième constante de réseau (A2) de la deuxième sous-cellule (SC2) et qu'une constante de réseau de la couche p⁺ de la première diode tunnel (TD1) est égale ou inférieure à la deuxième constante de réseau (A2) de la deuxième sous-cellule (SC2).

10. Cellule solaire multiple selon l'une des revendications précédentes, **caractérisée en ce que** la cellule solaire multiple comprend des sous-cellules supplémentaires (SC3, SC4) chacune avec une bande interdite supplémentaire (EG3, EG4), les sous-cellules supplémentaires (SC3, SC4) étant disposées entre la première diode tunnel (TD1) et la première sous-cellule (SC1), et les bandes interdites (EG3, EG4) des sous-cellules supplémentaires (SC3, SC4) étant chacune supérieures à la première bande interdite (EG1) de la première sous-cellule (SC1) et chacune inférieure à la deuxième bande interdite (EG2) de la deuxième sous-cellule (SC2).

11. Cellule solaire multiple selon la revendication 10, **caractérisée en ce que** la cellule solaire multiple comprend au moins une diode tunnel supplémentaire (TD2, TD3).

12. Cellule solaire multiple selon la revendication 10 ou 11, en ce que la au moins une diode tunnel supplémentaire (TD3) présente une couche intermédiaire supplémentaire (ZW2), une couche n⁺ de la diode tunnel supplémentaire (TD3) comprenant InAlP ou InGaP, une couche p⁺ de la diode tunnel supplémentaire (TD3) comprenant un matériau III-V contenant de l'arsenic, la couche intermédiaire supplémentaire (ZW2) étant disposée entre la couche n⁺ et la couche p⁺ de la diode tunnel supplémentaire (TD3) et la couche intermédiaire supplémentaire (ZW2) étant dans chaque cas plus fine que la couche n⁺ et que la couche p⁺ de la diode tunnel supplémentaire (TD3).

13. Cellule solaire multiple selon l'une des revendications 10 à 12, **caractérisée en ce que** la cellule solaire multiple est formée en tant que Ge / InGaAs / AlInGaAs / AlInGaP cellule à 4 jonctions ou la cellule solaire multiple est formée en tant que Ge / InGaAs / AlInGaAs / InGaP/ AlInGaP cellule à 5 jonctions.
